# EUROPEAN PATENT SPECIFICATION

(11) **EP 3 861 566 B1**
(45) Date of publication and mention of the grant of the patent: **12.01.2022**
(21) Application number: 19784031.7
(22) Date of filing: 06.10.2019
(51) Int. Cl.: H01J 37/34, C23C 14/34, C23C 4/12

(54) **PLANAR SPUTTERING TARGET**
PLANARES SPUTTERTARGET
CIBLE PLANE DE PULVÉRISATION

(30) Priority: 05.10.2018 BE 201805687
(43) Date of publication of application: 11.08.2021
(73) Proprietor: Soleras Advanced Coatings BV, 9800 Deinze (BE)
(72) Inventor: DE BOSSCHER, Wilmert, 9031 Drongen (BE); CARETTI GIANGASPRO, Ignacio, 2018 Antwerpen (ES); DEBRUYNE, David, Karel, 9000 Gent (BE); ELIANO, Hubert, 9860 Scheldewindeke (BE); FACK, Freddy, 9030 Mariakerke (BE); COTTENS, Tom, 9000 Gent (BE)
(74) Representative: DenK iP bv
(86) International application number: PCT/EP2019/076987
(87) International publication number: WO 2020/070324

(56) References cited:
- WO-A1-2005/090631
- GB-A- 2 239 462
- US-A1- 2015 329 955
- US-B2- 8 883 250

## Description

### Technical field of the invention

The present invention relates to planar sputtering targets and particularly to the fabrication of such planar sputtering targets.

### Background of the invention

Thermal spraying of a target material onto a planar or tubular carrier is a known method for the production of a sputtering target, which can be used as a source for forming thin coatings in a sputtering process (e.g. a magnetron sputtering process).

In a thermal spray process, superheated molten or semi-molten particles are projected at high velocities onto the proportionally much colder carrier material and solidify rapidly in a typical splat-like microstructure to form a coating of a desired thickness. Controlling the production temperature and microstructure of the thermally sprayed target material layer is crucial to minimize its internal stresses and hence the risk of target failure during sputtering by cracking or spallation, especially in the case of ceramic materials. In this regard, WO2005090631A1 reports the introduction of porosity via thermal spray in a rotary target material to reduce thermal stresses during sputtering. US 8883250 B2 discloses a planar sputtering target wherein an erosion-related recess exists, said recess being filled with a layering of splats using the cold-spray deposition technique. Also, US20120055783A1 describes the manufacture of either a planar or rotary sputtering target by thermal spraying assisted by cryogenic cooling jets, to reduce internal stresses without increasing porosity.

For sputtering targets, target erosion and utilization are always a concern and further improvements on this front are continuously sought. It is well known that the target utilization for planar targets is typically smaller than for rotary targets. Especially in the case of planar magnetrons, the target erosion is defined by a spatially varying anisotropic electromagnetic field distribution, leading to the formation of a localized erosion groove. As such, the material flux exiting the target surface as a result of the sputtering process will alter over time and will impact the deposition process on the substrate surface, as well as the redeposition process on the target surface. In practice, ejected particles from one side of the groove may be deposited more easily on the opposite side of the groove because of possible slight off-axis Ar+ ion impingement and because of the angular distribution of the ejected particles (e.g. following a Lambertian distribution); this is further referred to herein as the 'local avalanching effect'. Because of these effects, the erosion groove deepens relatively quickly (e.g. before significantly broadening), thereby rapidly reaching the bottom of the target material. Once the bottom of the target material is reached and the underlying material is exposed, the sputtering target must typically be replaced by a new target; otherwise sputtering of the underlying material and/or damage to the sputtering magnetron system might occur. The target utilization that can be achieved, particularly for planar targets, is therefore limited.

Furthermore, the properties of planar (e.g. rectangular, square or circular) and rotary (e.g. tubular) sputtering targets may differ considerably, even if both are manufactured by thermal spraying from the same source material. Indeed, the known manufacturing procedures for rotary targets have the spray source and the sputtering target carrier rotating with respect to one another about a central axis and translating with respect to one another in the direction of the central axis (e.g. a path which spirals around the target surface). Conversely, the known manufacturing procedures for planar targets have the spray source moving relative to the sputtering target carrier along a selected path (e.g. a path which "snakes" across the target surface). One consequence is that the overlapping of successive passes of sprayed target material on the sputtering target carrier differs between planar and rotary targets. Another consequence is that cooling of planar and rotary sputtering targets (e.g. through cooling of the carrier supporting the sputtering targets) during fabrication does not occur in the same way. Such and other differences lead to a potentially different microstructure of the target material and consequently to a different behaviour between planar and rotary sputtering targets when using them to deposit layers therefrom. In certain use cases, it would be useful to transfer established procedures for depositing layers from planar targets to corresponding procedures for rotary targets (or vice versa), or to judge the characteristics of a rotary target from a planar target sample (or vice versa). However, the currently known manufacturing procedures for planar and rotary sputtering targets do not straightforwardly allow doing so.

There is thus still a need in the art for better planar sputtering targets which address some or all of the problems outlined above, such as those related to residual stress, target utilization and/or the manufacturing method.

### Summary of the invention

It is an object of the present invention to provide good planar sputtering targets. It is a further object of the present invention to provide a good method for fabricating said planar sputtering targets. These objectives are accomplished by the products and the method according to the present invention.

In a first aspect, the present invention relates to a planar sputtering target, as defined in claim 1, comprising a target material layer built up by a layering of splats, wherein the layering of splats has a layer width and has a microstructure which varies across the layer width.

It is an advantage of embodiments of the present invention that planar sputtering targets with a potentially higher target utilization can be fabricated.

It is an advantage of embodiments of the present invention that, as a consequence of the anisotropic microstructure and porosity, stress relaxation within the target material layer may take place, yielding more robust (e.g. reliable) sputtering targets.

It is an advantage of embodiments of the present invention that they may contribute in counteracting on the undesired local avalanching effect.

In embodiments, the splats may have a preferential orientation and the microstructure varying across the layer width may comprise the preferential orientation varying across the layer width.

In embodiments, the preferential orientation with respect to a normal direction of the target material layer may undergo a change of sign across the layer width.

In embodiments, the microstructure varying across the layer width may comprise at least one property selected from a density, a porosity, a residual stress, and a crystallinity, of the target material layer varying across the layer width.

In embodiments, the layer composition across the layer width may remain substantially constant.

In embodiments, the planar sputtering target may have a target length and a target width, and the length may be longer than the width.

In embodiments, the splats may comprise an elemental non-metal, an elemental metal, an alloy, a metal compound or a ceramic material.

In embodiments, the planar sputtering target may further comprise a carrier underlying the target material layer.

In embodiments, a thickness of the carrier may be smaller than a thickness of the target material layer.

In embodiments, the carrier may have a top surface adapted for inducing thereon the varying microstructure across the layer width.

In embodiments, the planar sputtering target may further comprise a sacrificial structure interjected between a carrier underlying the target material layer and the target material layer, if a carrier is present, or underlying the target material layer, if no carrier is present.

In a second aspect, the present invention relates to a method for manufacturing a planar sputtering target, as defined in claim 12, comprising: (a) providing a carrier having a top surface (e.g. a front surface); and (b) spraying splats of target material onto the carrier from a spray source to form a target material layer built up by a layering of splats over the top surface, the layering of splats having a layer width, wherein the spray source makes an angle with the top surface and wherein the spray source and the backing structure move with respect to one another in such a way that the angle varies across the layer width.

It is an advantage of embodiments of the present invention that the layer thickness along the width of the as-prepared planar sputtering target may be varied by modifying the production parameters during thermal spraying without the need of a post processing step.

It is an advantage of embodiments of the present invention that the planar sputtering targets can be fabricated at a relatively high speed and in an economical fashion.

It is an advantage of embodiments of the present invention that planar sputtering targets with a thin carrier, or without carrier, can be fabricated.

It is an advantage of embodiments of the present invention that planar sputtering targets can be fabricated with both large and small dimensions.

It is an advantage of embodiments of the present invention that planar sputtering targets can be well cooled during fabrication. It is a further advantage of embodiments of the present invention that an adequate cooling can be achieved either with or without providing active cooling (e.g. active cooling of the backing structure, so as to cool down the planar sputtering target thereon).

It is an advantage of embodiments of the present invention that the carrier (e.g. the backing structure) or parts thereof, such as the support frame supporting the carrier plate, can be re-used. It is therefore a further advantage of embodiments of the present invention that it can be worthwhile to use more expensive, higher quality carriers.

It is an advantage of embodiments of the present invention that planar sputtering targets can be fabricated on a carrier with regions suitable for clamping the targets, e.g. to a sputtering magnetron.

In embodiments, the method may be for simultaneously manufacturing a plurality of planar sputtering targets, wherein steps (a) and (b) comprise: (a') providing a plurality of top surfaces, the top surfaces arranged about a central axis; and (b') spraying the target material onto the backing structure to form a target material layer on each of the top surfaces.

It is an advantage of embodiments of the present invention that a plurality of planar sputtering targets can be fabricated simultaneously.

It is an advantage of embodiments of the present invention that multiple planar sputtering targets can be fabricated using identical process conditions and thus similar product properties.

In embodiments, step b may comprise the spray source and the backing structure rotating with respect to one another.

It is an advantage of embodiments of the present invention that planar sputtering targets can be fabricated in a way which is more congruent with the fabrication of rotary sputtering targets. It is an advantage of embodiments of the present invention that planar sputtering targets can be fabricated that have characteristics that more closely match those of rotary sputtering targets. This may give the additional advantage that within a sputter coating production line, rotary sputtering targets may be exchanged with planar targets being produced according to the present invention and vice versa, while the need for changing sputter conditions may be minimal and the deposited layer quality may be more comparable. It is a further advantage of embodiments of the present invention that planar sputtering targets can be fabricated based on hardware which is currently employed for fabricating rotary sputtering targets.

In a third aspect, the present invention relates to a planar sputtering target, as defined in claim 15, obtainable by the method according to any embodiment of the second aspect.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 is a schematic representation of a planar sputtering target according to embodiments of the present invention.
FIG. 2 is a schematic vertical cross-section of a real planar sputtering target divided into several sections along its width, showing a first end, middle and opposite end section as wells as their corresponding optical microscopy images ; according to an exemplary embodiment of the present invention.
FIGs. 3-5 show (a) larger views of the microscopic images in FIG. 2 and (b) higher contrast versions of these larger views; according to an exemplary embodiment of the present invention.
FIG. 6 shows a bar chart of the preferential splat angle for the three sections shown in FIGs. 2-5.
FIG. 7 schematically shows the target utilization (a) for a prior art planar sputtering target and (b) for a planar sputtering target according to embodiments of the present invention.
FIG. 8 schematically represents a top view (a) and a side view (b) of a carrier having a structured surface, in accordance with embodiments of the present invention.
FIG. 9 is a schematic representation of the fabrication of planar sputtering targets by spraying, according to an exemplary embodiment of the present invention.
FIG. 10 shows different planar sputtering target profiles which can be obtained by varying the spraying parameters, as obtained through simulations in accordance with exemplary embodiments of the present invention.
FIG. 11 illustrates a different embodiment of the present invention, in which the backing structure is pre-shaped before application of the target material onto it, in order to accommodate for different target material layer thickness due to different spraying parameters being implemented over the width of the target, when applying the target material.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under, front, back and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still cooperate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practised without these specific details. In other instances, well-known methods, structures and techniques have not been shown in detail in order not to obscure an understanding of this description.

The following terms are provided solely to aid in the understanding of the invention.

As used herein, and unless otherwise specified, a splat is a microscopic entity obtained by projecting (e.g. spraying) particles (e.g. molten or semi-molten particles) of target material onto a surface (e.g. onto a top surface of a carrier or onto previously formed splats). By layering splats over one another, a target material layer (e.g. a target material coating) is obtained. In embodiments, the splats may comprise (e.g. consist of) amorphous and/or crystalline target material.

As used herein, and unless otherwise specified, a property denoted as a "splat [property]" corresponds to said property evaluated for a splat as such. For example, a splat composition may correspond to a composition within the boundaries of a splat. Within the present invention, such a splat property need not be constant for all splats and may vary from one splat to another.

As used herein, and unless otherwise specified, a property denoted as a "layer [property]" corresponds to said property evaluated beyond the splat boundaries, e.g. within a region of the target material layer (or within the target material layer as a whole). For example, the layer density may correspond to the density within a region of the target material layer, the region comprising an ensemble of splats and voids therebetween. In embodiments, the region of the target material layer may be selected such that it comprises at least 100 splats, preferably at least 500 splats, most preferably at least 2000 splats, up to for example 10000 or 100000 splats. Within the present invention, such a layer property need not be constant across the whole layer and, indeed, one or more layer properties will typically vary across the whole layer (e.g. across the layer width).

As used herein, and unless otherwise specified, the microstructure of a target material layer comprises (e.g. consists of) properties related to the splat orientation, the splat size, the splat shape, the splat crystallinity, the layer crystallinity, the layer density, the layer porosity, the layer structure, the layer order, the layer stress, etc.

As used herein, and unless otherwise specified, a structure may typically have a first dimension (e.g. a width), a second dimension (e.g. a length) and a third dimension (e.g. a thickness or height). In embodiments, these three dimensions may typically be perpendicular. In embodiments, the layer thickness may be the direction in which the layering of splats is built up, and the layer width and layer length may be perpendicular thereto. In embodiments, the target thickness, target width and target length may respectively be parallel to the layer thickness, layer width and layer length. In preferred embodiments, the layer width may be equal to or shorter than the layer length. Likewise, the target width may be equal to or shorter than the target length.

As used herein, and unless otherwise specified, a backing structure is a carrier for a target material layer, which is adapted for use in a method for manufacturing a sputtering target. In embodiments of the present invention, the backing structure can be pre-shaped in order to compensate for different layer thickness of applied target material at different locations over the width of the target material layer.

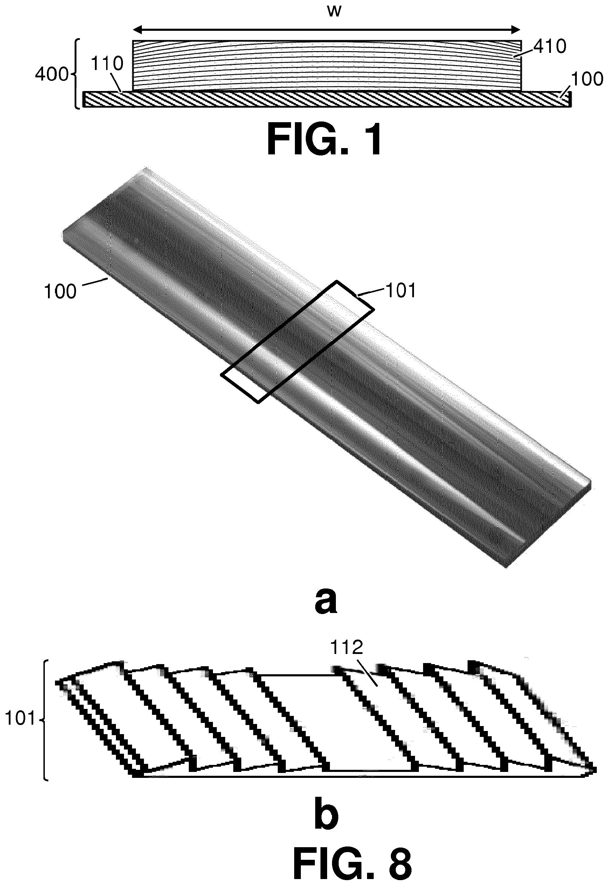

In a first aspect, the present invention relates to a planar sputtering target comprising a target material layer built up by a layering of splats, wherein the target material layer has a layer width and has a microstructure (and/or properties linked to it) which varies across the layer width. Such a planar sputtering target 400, comprising a target material layer 410 on a top surface 111 of a carrier 100 (cf. infra), is schematically depicted in FIG. 1. Herein the curved lines in the target material layer 410 represent the variation in morphology across the layer width (w).

In embodiments, the planar sputtering target may have a target length and a target width, the target length being equal to or longer than the target width. In preferred embodiments, the target length may be longer than the target width, e.g. the target length may be at least double or triple the target width. In embodiments, the target width may be at least 20 mm, preferably at least 50 mm, yet more preferably at least 100 mm, such as 113 mm or 120 mm. In embodiments, the target length may be at least 100 mm, preferably at least 500 mm, such as 800 mm. There is typically no upper limit for the target length and/or target width, but a practical limit for the target length may for example be set at 4000 mm. In embodiments, the layer width may be equal to or smaller than the target length. In embodiments, the layer width may be equal to or smaller than the target width.

In embodiments, the shape of the planar sputtering target may be rectangular, square, circular or elliptical. In preferred embodiments, the planar sputtering target may be a rectangular planar sputtering target. In embodiments, the planar sputtering target may have a substantially flat back surface (e.g. bottom surface). The planar sputtering target may advantageously be a target suitable for mounting on a planar magnetron.

In alternative embodiments, the planar sputtering target may comprise a rotary carrier. The planar sputtering target may for example advantageously be a planar polygonal sputtering target comprising (e.g. consisting of) one, two or more target material layers on a carrier (see e.g. example 3) suitable for mounting on a rotary magnetron. In embodiments, the planar sputtering target may comprise two or more carrier plates, each having a target material layer thereon, mounted on a polygonal support frame (e.g. a support frame having a polygonal profile; see e.g. example 3). In embodiments, the planar sputtering target may comprise a target material layer on two or more faces of a polygonal carrier (e.g. a carrier, such as a carrier tube).

In preferred embodiments, the microstructure varying across the layer width may not be due to (e.g. exclusively due to) a change in layer composition (e.g. a change in the average splat composition between regions of the target material layer). In embodiments, the sputtering target may comprise an elemental non-metal, an elemental metal, an alloy, a metal compound, a ceramic material, or a combination thereof. In embodiments, the target layer may comprise aluminum-doped zinc oxide (AZO), Cr, CuGa, indium tin oxide (ITO), Mo, Ni, a Ni alloy (e.g. NiCr), NbOx, Si, SiAl, Sn, TiOₓ, a W alloy, Zn, a Zn alloy (e.g. ZnSn or ZnAI), ZnO, ZrOₓ and zinc tin oxide (ZTO). The planar sputtering target may typically have a material composition (e.g. a layer compostion) having an intrinsic density. In embodiments, the target material layer may have a density of 99% of the intrinsic density or lower, possibly 97% or lower, yet more realistically 95% or lower, even 92% or lower, such as 90% or lower. In embodiments, the layer composition across the layer width may remain substantially constant. For example, a change of the layer composition across the layer width may be 5 at% or smaller, preferably 2 at% or smaller; alternatively, the layer composition across the layer width may be 2 wt% or smaller, preferably 1 wt% or smaller. In embodiments, the splat composition between two distinct splats may vary considerably (e.g. even if the layer composition is substantially constant). This may for example be the case when the target material layer is formed by spraying (e.g. simultaneously) two or more materials. In preferred embodiments, the distribution of the splat composition across the layer width may be substantially constant.

In embodiments, the target material layer (e.g. the splats) may be obtained by spraying, e.g. by thermal spraying or cold spraying. In embodiments, the target material layer may have a substantially flat, a concave or a convex top surface; preferably flat or convex. In embodiments, the target material layer may have a thickness of at least 1 mm, preferably at least 5 mm, yet more preferably at least 10mm, such as 20 mm or more.

Within the present invention, the microstructure varying across the layer width may typically be due to an incident angle (e.g. an average incident angle) of the projected particles with respect to the surface varying across the layer width. For example, a spray source may be moved with respect to the surface (or vice versa) in such a way that its angle with respect to the surface varies across the layer width; the spray source may, for example, trace a section of a hemispherical path relative to a plane surface (e.g. the top surface of the backing structure or the top surface of the sputtering target). As such, different locations along the width direction will experience a different average incident angle of the particles projected from the spray source.

In order to judge whether the microstructure (e.g. the preferential orientation or the layer density) varies across the layer width, one may for example (e.g. virtually) divide the target material layer in a number (e.g. from 2 to 10) of portions (e.g. sections) across the layer width and compare the microstructure within each portion. For example, the target material layer could be subdivided across the layer width into a left section, possibly a middle section and a right section, these sections for instance having equal widths.

In embodiments, the splats may have a preferential orientation and the microstructure varying across the layer width may comprise the preferential orientation varying across the layer width. In embodiments, the angle of preferential orientation with respect to a normal direction of the target material layer may undergo a change of sign across the layer width (w). In embodiments, the preferential orientation with respect to a normal direction of the target material layer may be positive towards a first end along the layer width, negative towards an opposing end along the layer width and may vary gradually therebetween. The normal direction of the target material layer may for example be a direction perpendicular to the surface of the carrier, if present. In embodiments, the preferential orientation may be the average splat orientation or the predominantly found splat orientation or the theoretically most likely splat orientation for the splats within the region of consideration. In embodiments, the splat orientation may correspond to the thickness direction of the splat. For example, after subdividing (cf. supra) the target material layer into a left section, possibly middle section and right section, the preferential orientation may be found to point substantially upwards (e.g. parallel to the layer thickness direction) in the middle section, left-tilted in the left section and right-tilted in the right section.

In embodiments, the microstructure varying across the layer width may comprise at least one property of the target material layer varying across the layer width. The at least one property may for example be a density, a porosity, a residual stress, a crystallinity or a layer thickness. For example, after subdividing (cf. supra) the target material layer into a left section, possibly middle section and right section, the layer density may be found to be higher in the middle section than in the left and right section.

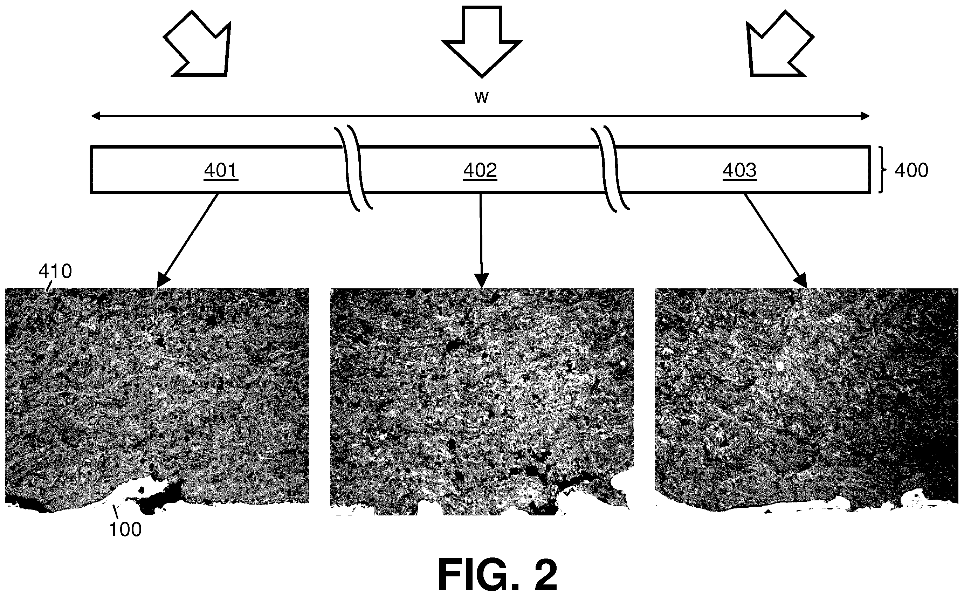

Reference is now made to FIG. 2. In the middle, a TiOₓ target material layer 410 of a planar sputtering target 400 is schematically depicted, three sections 401-403 along the layer width w are further indicated. The large arrows give an indication of the angle of the spray source above each section. Representative optical microscopy images (1.3 x 1.1 mm) for each of the sections 401 to 403 are depicted at the bottom of FIG. 2. The microscopy images are taken along the cross section of the target material layer.

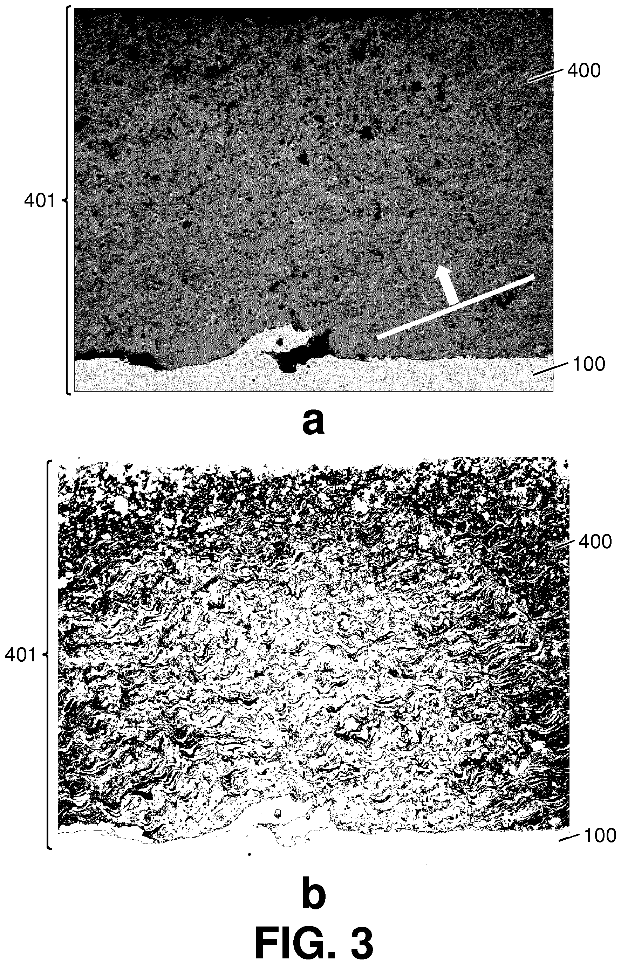

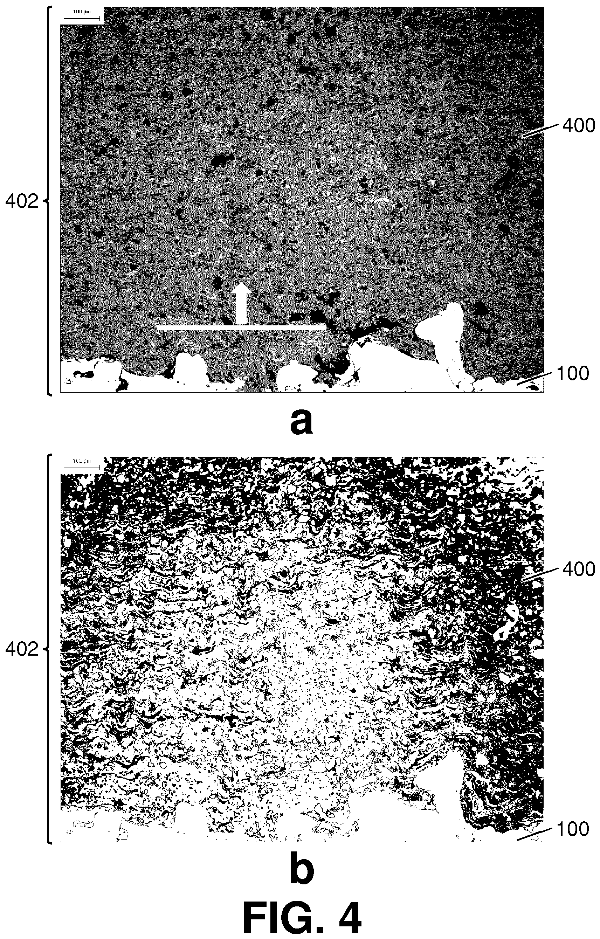

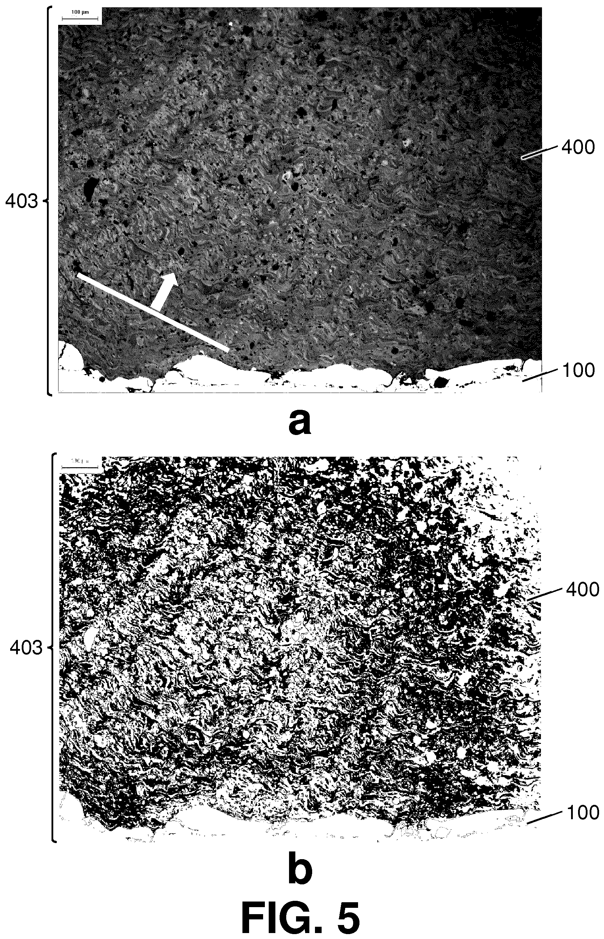

A larger version of these images is shown for each of the sections 401, 402 and 403 in FIGs. 3, 4 and 5 respectively. FIGs. 3a-5a correspond to the images as depicted in FIG. 2, while FIG. 3b-5b correspond to these images with increased contrast. The individual splats that make up the target material layer 410 may be distinguished in these images. To guide the eyes, a line is shown in FIGs. 3a-5a corresponding to the general layering of the splats and an arrow is shown to indicate the preferential splat orientation. As seen, the preferential splat orientation shifts from left tilted in left section 401, to upwards in middle section 402, to right tilted in right section 403; giving a clear indication of the changing microstructure across the layer width w.

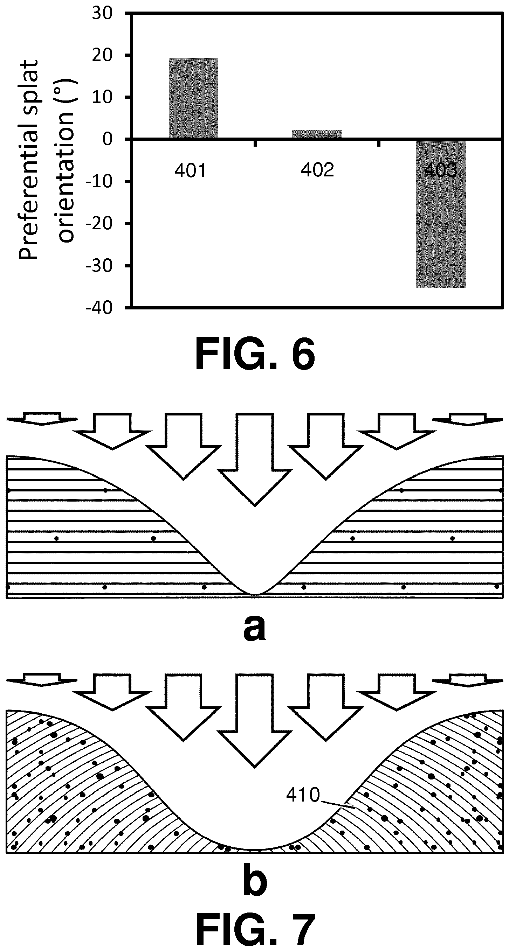

FIG. 6 shows the preferential splat orientation for each of the sections 401-403. The preferred angles were derived from the microscopy images depicted in FIGs. 3a-5a using the ImageJ image processing software (ImageJ.net). The procedure consisted of two steps. Firstly, an area filter was applied to highlight the edges of the splats. Secondly, the Directionality plugin was used (with the Fourier components method) to infer the preferred orientation of the splats.

FIG. 7a shows a schematic representation of the target utilization for prior art planar sputtering targets in a sputtering magnetron. Lines in the sputtering target indicate the layering of splats and dots indicate the presence of voids in the sputtering target (i.e. represent the porosity of the sputtering target). The arrows correspond to the incident Ar⁺-ions or reactive gas ions. The incident ion density is not equally distributed over the target width as a result of the non-uniform plasma confinement from the electromagnetic field. As the material of the planar sputtering target is used up by sputtering, a track is eroded into the planar sputtering target. This track is typically relatively narrow in the prior art planar sputtering targets, resulting in a relatively low target utilization.

Conversely, FIG. 7b shows a schematic representation of the target utilization in a sputtering magnetron for planar sputtering targets 400 according to embodiments of the present invention. Lines in the sputtering target again indicate the layering of splats and dots represent the porosity of the sputtering target. Contrary to the prior art planar sputtering target, the present planar sputtering target 400 has a microstructure which varies across the target width, with e.g. a higher porosity towards the edges. As such, moving from the middle to the edges, the sputtering material is increasingly characterized by a higher surface area and lower binding energy and is therefore more readily dislodged from the planar sputtering target. This effectively leads to a broadening of the eroded track and thus a higher target utilization. The porosity furthermore allows relaxation within the target material layer to take place, relieving residual stresses and yielding more robust (e.g. reliable) sputtering targets.

In embodiments, the planar sputtering target may consist of the target material layer. In other embodiments, the planar sputtering target may further comprise a carrier (e.g. a carrier plate, carrier frame, polygonal carrier tube, or carrier profile) underlying the target material layer. The carrier may be in turn mounted on a backing structure to support it during production of the target. The planar sputtering target can advantageously comprise (e.g. consist of) a target material layer on a carrier. The planar sputtering target can also be formed directly on the backing structure during the fabrication of the planar sputtering target, in which case the backing structure acts as carrier.

In embodiments, a thickness of the carrier may be smaller than a thickness of the target material layer. In embodiments, the thickness of the carrier may measure 1 cm or less, preferably 5 mm or less, such as 4 mm or less. The present invention advantageously allows the target material layer to be present (e.g. formed) on a thin carrier.

In embodiments, the carrier may comprise (e.g. consist predominantly of) one or more metals. In embodiments, the one or more metals may be selected from Al, Cu, Ti, Mo and Fe. In embodiments, the carrier may consist substantially of a material selected from Al, Cu, Ti, Mo and steel (e.g. stainless steel). The carrier may typically have a material composition having an intrinsic density.ln embodiments, the carrier may have a density of 95% of the intrinsic density or higher, preferably 98% or higher, yet more preferably 99% or higher.

In embodiments, the carrier may have a top surface adapted for inducing thereon the varying microstructure across the layer width. In embodiments, the carrier may have a curved surface (e.g. a section of a hemispherical surface) for promoting an incident angle of the particles projected from the spray source to vary across the layer width. In embodiments, the carrier may have a structured surface for promoting an incident angle of the particles projected from the spray source to vary across the layer width. In embodiments, the structured surface may comprise ridges and/or peaks and/or valleys. An example of such a structured surface is shown in FIG. 8, schematically depicting a top view (a) of a carrier 100 with structured surface and a side view (b) of the section 101 of the carrier 100 comprising a structured surface 112 with a sawtooth profile.

In embodiments, the carrier may have a top surface adapted for promoting adhesion of the splats thereon. In embodiments, the carrier may have a structured surface for promoting adhesion of the splats thereon. In embodiments, the structured surface may be a rough (e.g. non-smooth) surface. In embodiments, the carrier may have a structured surface simultaneously promoting an incident angle of the particles projected from the spray source to vary across the layer width and promoting adhesion of the splats on the structured surface. In embodiments, the carrier may have an adhesion promoting layer (e.g. an adhesion promoting overlay structure) applied onto the top surface for promoting adhesion of the splats thereon. In embodiments, the adhesion overlay layer may comprise (e.g. consist of) a metal layer, an alloy layer or a compound layer. In preferred embodiments, the adhesion promoting layer may have a thickness less than 2 mm, e.g. less than 1 mm, for example 0.5 mm or even less.

In embodiments, the planar sputtering target may further comprise a sacrificial structure interjected between the carrier and the target material layer, if a carrier is present, or underlying the target material layer if no carrier is present. In embodiments, the sacrificial structure may be a thin flexible sheet (e.g. a carbon paper). In embodiments, the sacrificial structure may have a low melting temperature. In embodiments, the sacrificial structure may be removable from the target material layer.

In embodiments, any feature of any embodiment of the first aspect may independently be as correspondingly described for any other aspect or their embodiments.

In a second aspect, the present invention relates to a method for manufacturing a planar sputtering target, comprising: (a) providing a backing structure having a top surface (e.g. a front surface); and (b) spraying splats of target material onto the backing structure from a spray source to form a target material layer over the top surface, the target material layer having a layer width, wherein the spray source makes an angle with the top surface and wherein the spray source and the backing structure move with respect to one another in such a way that the angle varies across the layer width.

In embodiments, the backing structure may have a cross-sectional profile corresponding to an irregular or regular polygon (e.g. a regular triangle, square, pentagon, hexagon, octagon, dodecagon, hexadecagon, etc.). In some embodiments, the backing structure may be substantially monolithic. In other embodiments, the backing structure may comprise two or more parts, such as one or more carrier plates mounted on a support frame. In embodiments, the backing structure may be suitable for cooling the top surface. In embodiments, the backing structure may be a hollow backing structure. The backing structure may, for example, be a hollow backing structure (e.g. a tube, for example with a polygonal profile) through which a cooling fluid for cooling the top surface (e.g. cooling the target material layer) can flow. In embodiments, the thickness of the backing structure (e.g. the thickness of the backing structure surrounding the hollow or the thickness of the carrier plate) may measure e.g. 20 mm or less, such as 10 mm or less, preferably 5 mm or less, such as 4 mm or less. Monolithic backing structures or carrier plates used in the present method are typically less prone to deformation, for example because of improved cooling (particularly with respect to the known methods for making planar structures by thermal spraying on an uncooled backing structure) and/or because of additional support provided by the support frame; as such they may advantageously be thinner. In embodiments, the support frame may be somewhat thicker than the carrier plate. In this way, the support frame can better handle thermal and/or mechanical stresses due to the spraying process and can therefore better support the carrier plate.

Since the backing structure is typically a particular kind of carrier, features of the backing structure (e.g. the material composition) may, in embodiments, independently be as previously described for the carrier (and vice versa). In embodiments, the backing structure may comprise a material composition (cf. supra) selected in function of the target material layer to be formed thereon. For example, the carrier plate or the monolithic backing structure may consist of a material composition selected such that its thermal expansion coefficient approximates that of the target material layer to be formed thereon and/or such that a good adhesion between the target material and the backing structure (e.g. the carrier plate) is achieved. In embodiments, the support frame may consist of a material composition selected to achieve a good mechanical stability.

In embodiments, step (b) may comprise the spray source and the backing structure rotating with respect to one another. In embodiments, step (b) may comprise the spray source and the backing structure rotating with respect to one another about an axis. In embodiments, the spray source and the backing structure may spiral (i.e. rotate and translate) with respect to one another (e.g. about the axis). In embodiments, the axis may be a common axis, such as the longitudinal axis of the backing structure. By moving (e.g. rotating or spiraling) the spray source and the backing structure relative to one another, the point of incidence of the spray source moves over the top surface of the backing structure and the previously sprayed area of the backing structure is thereby allowed to cool down. Simultaneous with the movement of the point of incidence, the required variation in the angle varies across the layer width can advantageously be achieved. In embodiments, the backing structure may rotate about the axis (e.g. when the axis is the longitudinal axis of the backing structure, said backing structure may rotate upon itself). By rotating the backing structure as such (rather than or in combination with rotation of the spray source), the cooling of the backing structure is advantageously further aided. In such embodiments, the spray source may translate along the axis of rotation of the backing structure. Through the combined motion of rotation of the backing structure and translation of the spray source, the point of incidence can advantageously be made to spiral around the top surface.

In embodiments, spraying in step (b) may comprise thermal spraying or cold spraying, preferably thermal spraying. In embodiments, thermal spraying may comprise plasma spraying, arc spraying or combustion spraying, preferably plasma spraying. In embodiments, the spraying may be a computer-controlled spraying.

In embodiments, the method may further comprise a step (c), performed after step (b), of separating the target material layer from the carrier. A planar sputtering target without a carrier may thereby be advantageously obtained. In some applications, it may be beneficial to use a planar sputtering target without carrier, e.g. because cooling of the target material layer can be achieved more efficiently and/or the trajectory of magnetic field lines can be improved. In embodiments, the backing structure may comprise a support frame and a carrier plate mounted thereon (cf. supra), and step (c) may comprise dismounting the carrier plate from the support frame. In embodiments, a sacrificial structure may be present, e.g. provided, on the backing structure prior to performing step (b), and step (c) may comprise separating the sacrificial structure from the backing structure and/or separating the target material layer from the sacrificial structure.

In embodiments, the method may be for simultaneously manufacturing a plurality of planar sputtering targets, wherein steps (a) and (b) comprise: (a') providing a plurality of top surfaces, the top surfaces arranged about a central axis; and (b') spraying the target material onto the backing structure to form a target material layer on each of the top surfaces. In embodiments, the method may further comprise a step (d'), performed after step (b') and optionally before or after a step (c') of separating a sacrificial structure from the backing structure and/or separating the target material layer from the sacrificial structure, step (d') being a step of separating the planar sputtering targets arranged about the central axis, so as to obtain individual planar sputtering targets. In embodiments, the backing structure may be substantially monolithic and separating the planar sputtering targets in step (d') may comprise cutting up the backing structure. In embodiments, the backing structure may comprise a support frame and a plurality of carrier plates mounted thereon and separating the planar sputtering targets arranged about the central axis may comprise dismounting the plurality of carrier plates. In embodiments, the plurality of carrier plates may consist of 2, 3, 4, 5, 6, 8, 12, 16 or more carrier plates. By disassembling (e.g. dismounting the carrier plates) or cutting up the backing structure, a planar sputtering target consisting partially of the backing structure (i.e. as a carrier; for example in the form of a carrier plate) and partially of the target material layer is advantageously realized.

In embodiments, any feature of any embodiment of the second aspect may independently be as correspondingly described for any other aspect or their embodiments.

In a third aspect, the present invention relates to a planar sputtering target, obtainable by the method according to any embodiment of the second aspect.

In embodiments, any feature of any embodiment of the third aspect may independently be as correspondingly described for any other aspect or their embodiments.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: Fabrication of a plurality of planar sputtering targets

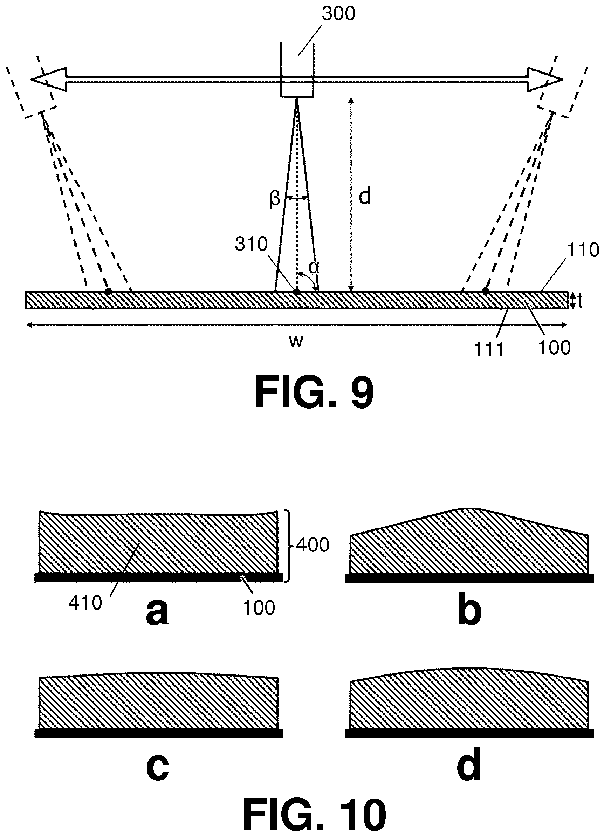

Reference is now made to FIG. 9, which shows a schematic representation of the fabrication of planar sputtering targets by spraying (e.g. thermal spraying) in accordance with embodiments of the present invention. Depicted is a backing structure 100 with thickness t, a face of which forms top surface 110 with width w. Though not depicted in FIG. 9, the backing structure 100 may comprise multiple faces, e.g. arranged about an axis, each having a top surface 110. The backing structure 100 allows cooling down the top surface 110 through bottom surface 111, e.g. by flowing a cooling liquid therealong. A spray source 300 (e.g. spray gun) projects particles (typically in a cone with spread β) onto the top surfaces 110 to build up a target material layer (not separately depicted) through a layering of splats. Meanwhile, the hollow backing structure 100 rotates an axis (and/or the spray source 300 rotates/tilts with respect to the top surface 110), so that the spray source 300 and the top surfaces 110 rotate with respect to one another. In doing so, the angle α of the spray source 300 with respect to the top surface 110 (and therefore the average angle of incidence of the projected particles) changes throughout the rotation. As depicted in FIG. 9, the angle α as illustrated is 90° and in the case of a square profile will lower to 45° as the edge of the top surface 110 rotates towards the central point of incidence 310 of the spray source 300; and will subsequently rise again to 90° as the middle of the top surface 110 rotates back towards the central point of incidence 310. Simultaneously, the spray distance d will likewise fluctuate between a maximum and a minimum; for the situation depicted in FIG. 9, the maximum d coincides with the angle α being 90°, while the minimum d coincides with the angle α being 45°.

Alongside the rotation, the spray source 300 also translates relative to the backing structure 100 (i.e. the spray source 300 translates, the backing structure 100 translates, or both translate), along the length direction (perpendicular to the width). In this way, the spray source 300 can cover the entire backing structure 100 (i.e. the full area of top surface 110): the width of the backing structure 100 (i.e. the full width of top surface 110) through the relative rotational movement and the entire length through the relative translational movement. Preferably, the translation may occur simultaneously with the rotation, i.e. the spray source 300 may spiral about the axis relative to the backing structure 100 and top surface 110. Alternatively, the spray source 300 may rotate relatively for some amount (e.g. a full revolution) and then translate relatively for a short distance before continuing the relative rotation. In addition, both backing structure 100 and spray source 300 may carry part of the movements, independently or dependently. Independently; the spray source 300 may e.g. rotate about an axis around the backing structure 100 that is making a translational movement. Dependently, the backing structure 100 may e.g. rotate about the central axis and the spray source 300 may make a synced movement related to the instantaneous rotation angle of the backing structure 100. For example, for a backing structure with a square profile having four top surfaces 110, the synced movement of the spray source 300 may e.g. have a frequency that is 4 times higher than the rotation speed of a square backing structure, as to generate the same deposition profile on each of the four faces 110. The movement of the spray gun 300 may comprise or consist of tilting and translation. The rotation speed about the axis may be variable as well, possible synced with the instantaneous rotation angle.

After completing the formation of the target material layer, the structure can be split into one or more planar sputtering targets; this is not depicted in FIG. 9. Splitting could, for example, be achieved by cutting up the backing structure 100 along the edges of the top surface 110, and, optionally, perpendicular to the length direction. Any number of planar sputtering targets could in this way be obtained. Alternatively, the backing structure could comprise a support frame with one or more carrier plates reversibly mounted on the faces thereof. In that case, the plurality of planar sputtering targets can be obtained straightforwardly by dismounting the carrier plates from the support frame. These can again be optionally cut into further, smaller, planar sputtering targets.

### Example 2: Expectations on the sputtering target profile

As the spray source rotates relative to the backing structure 100 during manufacturing of the planar sputtering targets 400, the spray angle α and the spray distance d change, as explained in example 1. Furthermore, also the relative circular movement speed varies for different points on the top surface, with points near the edge (e.g. a corner) of the top surface moving faster than points near the middle of the top surface. These differences can be leveraged to tailor the obtained sputtering target profile through control of the spraying parameters.

FIG. 10 shows different sputtering target profiles which can be obtained by varying the spraying parameters. Depicted are vertical cross-sections (parallel to the width w) of planar sputtering targets 400, consisting of a target material layer 410 on a backing structure 100. In the embodiments illustrated in FIG. 10, the backing structure is flat in a vertical cross-section parallel to the width w of the targets 400. The spraying parameters that may be adjusted during the production process are: beam divergence, spray distance, spray material flux, tilting of the spray source and rotation speed. Each of these parameters may be chosen to be constant during the spraying process, though may be variable and more particularly may be dependent on and specific for the absolute angle of the circular movement (being a rotation of the backing structure for a steady or translating spray source, being a rotation of the spray source for a steady or translating backing structure or being a combination of both for a specific relative position of the spray source vs the backing structure). Take as an example a backing structure having a square profile along the longitudinal direction and having an axis of rotation being defined by the crossing diagonals of the square profile; i.e. the center axis of the profile. In addition, let us define a rotation angle having 0° when the line connecting the spray source position to the center axis of the profile intersects the square profile in the middle of any of the four faces. At this specific position, specific values of the spraying parameters may be chosen. As a result, for a rotation angle of 45°, we may expect that an edge of the square profile is pointing towards the spray source. For constant spraying parameters, the edge will be closer to the spray source and depending mainly on the beam divergence may experience a higher deposit under this condition. However, the residence time for the edge will be shorter because of having a higher movement speed (for constant angular speed). In addition, the angle of incidence of the sprayed particles on the backing structure will be varying as well depending on the spraying conditions; all contributing to a specific thickness profile. For a square profile, it may be advantageous to introduce cyclical changes in the spraying conditions with a frequency thereof being 4 times (equal to the number of sides on the backing structure) higher than the circular movement. For example; the spraying distance, material flux, rotation speed and tilting angle may have preferential values for a rotation angle of 0°, 90°, 180° and 270°, while a different set of parameters may be desired for 45°, 135°, 225° and 315°. Changes between those two parameters sets may vary linearly, according to a sine wave or any shape that is advantageous for generating the desired layer thickness profile or desired microstructure on the carrier along its width. For example, combining the tilting of the spray gun in sync (at quadruple frequency) with the circular movement may increase or decrease the residence time of the spray flux at a desired area of the backing structure and/or the carrier. If the backing structure is a polygon with a different number of edges and flat areas, the multiple on the syncing frequency vs the circular movement speed/frequency may be chosen accordingly.

As is visible in FIG. 10, control of these spraying parameters, can allow tailoring the obtained sputtering target profiles between concave (FIG. 10a), convex (FIG. 10d) and intermediates, such as pointed (FIG. 10b) or relatively flat (FIG. 10c).

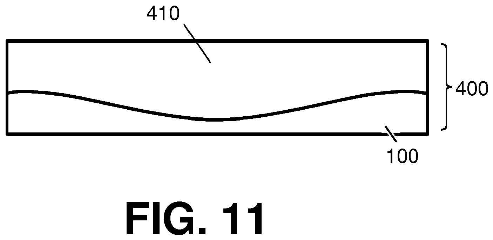

In accordance with embodiments of the present invention, as illustrated in FIG. 11, the backing structure 100 may be pre-shaped, e.g. may have received, before application of the target material onto it by spraying, a shape which corresponds to, e.g. is substantially the inverse of, or preferably even exactly the inverse of, the layer thickness profile which would be obtained in the target material layer 410 by spraying with particular spraying parameters onto a flat backing structure 100. When spraying, with these spraying parameters, target material onto such pre-shaped backing structure 100, a substantially flat target is obtained.

Obviously, in order to obtain as an end result a substantially flat target, the pre-shaping of the backing layer 100 should be done in correspondence with the spraying parameters which will be implemented when spraying target material onto the pre-shaped backing layer. Application of different spraying parameters requires a differently pre-shaped backing layer in order to finally obtain a substantially flat sputtering target.

### Example 3: Backing structure designs

A few different hollow backing structure designs are described below. These backing structures may comprise a support frame with carrier plates reversibly mounted on faces thereof.

A first design may be comprising four carrier plates mounted on a hollow support frame with a square profile. The carrier plates may be attached to the support frame by means of clamping structures along the edges. The clamping structures slightly overhang the carrier plates, which beneficially limits the width over which the target material layer can be deposited. After removing the clamping structures, these borders which are not covered by the target material layer are advantageously suitable for clamping the planar sputtering target to a further structure, e.g. to a sputtering magnetron.

Another design may be comprising two carrier plates mounted on the hollow support frame with the square profile and attached thereto by clamping structures. In this case also, the clamping structures may slightly overhang the carrier plates. In this embodiment with two carrier plates, the hollow support frame may be preferentially rectangularly shaped.

Yet another design may be comprising six or eight carrier plates mounted on a hollow support frame with a respectively hexagonal or octagonal profile. In order to attach the carrier plates without clamping structures, they may for example be soldered or glued to the support frame.

It will be clear that these are but exemplary designs and that many more types of backing structures may be used in accordance with embodiments of the present invention; e.g. comprising from 2 to 16 or more carrier plates, with or without clamping structures. Furthermore, it is recalled that the backing structures may also have a substantially monolithic form, which is eventually cut up after the deposition of the target material layer (cf. example 1).

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention. The invention is defined by the claims.

## Claims

1. A planar sputtering target (400) comprising a target material layer (410) built up by a layering of splats, wherein the layering of splats has a layer width (w) and has a microstructure which varies across the layer width (w).

2. The planar sputtering target (400) according to claim 1, wherein the splats have a preferential orientation and wherein the microstructure varying across the layer width (w) comprises the preferential orientation varying across the layer width (w).

3. The planar sputtering target (400) according to claim 2, wherein the preferential orientation with respect to a normal direction of the target material layer (410) undergoes a change of sign across the layer width (w).

4. The planar sputtering target (400) according to any of the previous claims, wherein the microstructure varying across the layer width (w) comprises at least one property selected from a density, a porosity, a residual stress, and a crystallinity, of the target material layer (410) varying across the layer width (w).

5. The planar sputtering target (400) according to any of the previous claims, wherein the layer composition across the layer width (w) remains constant.

6. The planar sputtering target (400) according to any of the previous claims, having a target length and a target width, the length being longer than the width.

7. The planar sputtering target (400) according to any of the previous claims, wherein the splats comprise an elemental non-metal, an elemental metal, an alloy, a metal compound or a ceramic material.

8. The planar sputtering target (400) according to any of the previous claims, further comprising a carrier (100) underlying the target material layer (410).

9. The planar sputtering target (400) according to claim 8, wherein a thickness (t) of the carrier (100) is smaller than a thickness of the target material layer (410).

10. The planar sputtering target (400) according to claim 8 or 9, wherein the carrier (100) has a top surface (110) adapted for inducing thereon the varying microstructure across the layer width (w).

11. The planar sputtering target (400) according to any of the previous claims, further
comprising a sacrificial structure interjected between a carrier (100) underlying the target material layer (410) and the target
material layer (410), if a carrier (100) is present, or underlying the target material layer (410), if no carrier (100) is present.

12. A method for manufacturing a planar sputtering target (400),
a. providing a backing structure (100) having a top surface (110); and
b. spraying splats of target material onto the backing structure (100) from a spray source (300) to form a target material layer (410) built up by a layering of splats over the top surface (110), the layering of splats having a layer width (w), wherein the spray source (300) makes an angle (α) with the top surface (110) and wherein the spray source (300) and the backing structure (100) move with respect to one another in such a way that the angle (α) varies across the layer width (w).

13. The method according to claim 12, for simultaneously manufacturing a plurality of planar sputtering targets (400), steps a and b comprising:
a'. providing a plurality of top surfaces (110), the top surfaces (110) arranged about a central axis (200); and
b'. spraying the splats onto the backing structure (100) to form a target material layer (410) on each of the top surfaces (110).

14. The method according to claim 12 or 13, wherein step b comprises the spray source (300) and the backing structure (100) rotating with respect to one another.

15. A planar sputtering target (400), obtainable by the method according to any of claims 12 to 14.

## Patentansprüche

1. Ein flächiges Sputterziel (400), das eine Zielmaterialschicht (410) umfasst, die durch eine Aufschichtung von Spritzern gebildet wird, wobei die Aufschichtung von Spritzern eine Schichtbreite (w) aufweist und eine Mikrostruktur aufweist, die über die Schichtbreite (w) variiert.

2. Das flächige Sputterziel (400) nach Anspruch 1, wobei die Spritzer eine bevorzugte Ausrichtung aufweisen und wobei die Mikrostruktur, die über die Schichtbreite (w) variiert, die bevorzugte Ausrichtung über die Schichtbreite (w) variierend umfasst.

3. Das flächige Sputterziel (400) nach Anspruch 2, wobei die bevorzugte Ausrichtung in Bezug auf eine normale Richtung der Zielmaterialschicht (410) einer Vorzeichenänderung über die Schichtbreite (w) unterliegt.

4. Das flächige Sputterziel (400) nach einem der vorstehenden Ansprüche, wobei die über die Schichtbreite (w) variierende Mikrostruktur mindestens eine Eigenschaft, die aus einer Dichte, einer Porosität, einer Restspannung und einer Kristallinität ausgewählt ist, der Zielmaterialschicht (410) umfasst, die über die Schichtbreite (w) variiert.

5. Das flächige Sputterziel (400) nach einem der vorstehenden Ansprüche, wobei die Schichtzusammensetzung über die Schichtbreite (w) konstant bleibt.

6. Das flächige Sputterziel (400) nach einem der vorstehenden Ansprüche, das eine Ziellänge und eine Zielbreite aufweist, wobei die Länge länger als die Breite ist.

7. Das flächige Sputterziel (400) nach einem der vorstehenden Ansprüche, wobei die Spritzer ein elementares Nichtmetall, ein elementares Metall, eine Legierung, eine Metallverbindung oder ein Keramikmaterial umfassen.

8. Das flächige Sputterziel (400) nach einem der vorstehenden Ansprüche, weiter umfassend einen Träger (100), der unter der Zielmaterialschicht (410) liegt.

9. Flächiges Sputterziel (400) nach Anspruch 8, wobei eine Dicke (t) des Trägers (100) kleiner als eine Dicke der Zielmaterialschicht (410) ist.

10. Das flächigee Sputterziel (400) nach Anspruch 8 oder 9, wobei der Träger (100) eine Oberseitenoberfläche (110) aufweist, die angepasst ist, die über die Schichtbreite (w) variierende Mikrostruktur darauf hervorzurufen.

11. Das flächige Sputterziel (400) nach einem der vorstehenden Ansprüche, weiter umfassend eine Opferstruktur, die zwischen einem Träger (100), der unter der Zielmaterialschicht (410) liegt, und der Zielmaterialschicht (410) eingefügt ist, falls ein Träger (100) vorhanden ist, oder unter der Zielmaterialschicht (410) liegt, falls kein Träger (100) vorhanden ist.

12. Ein Verfahren zum Herstellen eines flächigen Sputterziels (400),
a.- Bereitstellen einer Grundstruktur (100), die eine Oberseitenoberfläche (110) aufweist; und
b.- Sprühen von Spritzern von Zielmaterial auf die Grundstruktur (100) von einer Sprühquelle (300), um eine Zielmaterialschicht (410) zu bilden, die aus einer Aufschichtung von Spritzern über die Oberseitenoberfläche (110) gebildet ist, wobei die Aufschichtung von Spritzern eine Schichtbreite (w) aufweist, wobei die Sprühquelle (300) einen Winkel (α) mit der Oberseitenoberfläche (110) bildet und wobei die Sprühquelle (300) und die Grundstruktur (100) sich in Bezug aufeinander so bewegen, dass der Winkel (α) über die Schichtbreite (w) variiert.

13. Das Verfahren nach Anspruch 12 zum gleichzeitigen Herstellen einer Vielzahl von flächigen Sputterzielen (400), wobei Schritte a und b umfassen:
a`.- Bereitstellen einer Vielzahl von Oberseitenoberflächen (110), wobei die Oberseitenoberflächen (110) um eine Mittelachse (200) angeordnet sind; und
b`.- Sprühen der Spritzer auf die Grundstruktur (100), um eine Zielmaterialschicht (410) auf jeder der Oberseitenoberflächen (110) zu bilden.

14. Das Verfahren nach Anspruch 12 oder 13, wobei Schritt b die Sprühquelle (300) und die Grundstruktur (100) in Bezug aufeinander drehend umfasst.

15. Ein flächiges Sputterziel (400), das durch das Verfahren nach einem der Ansprüche 12 bis 14 erhältlich ist.

## Revendications

1. Une cible de pulvérisation plane (400) comprenant une couche de matériau de cible (410) accumulée par une superposition de lattes, dans laquelle la superposition de lattes présente une largeur de couches (w) et comporte une microstructure qui varie sur la largeur de couche (w).

2. La cible de pulvérisation plane (400) selon la revendication 1, dans laquelle les lattes présentent une orientation préférentielle et dans laquelle les microstructures variant sur la largeur de couche (w) comprennent l'orientation préférentielle variant sur la largeur de couche (w).

3. La cible de pulvérisation plane (400) selon la revendication 2, dans laquelle l'orientation préférentielle par rapport à une direction normale de la couche de matériau de cible (410) subit un changement de signe sur la largeur de couche (w).

4. La cible de pulvérisation plane (400) selon l'une quelconque des revendications précédentes, dans laquelle la microstructure variant sur la largeur de couche (w) comprend au moins une propriété sélectionnée parmi une densité, une porosité, une contrainte résiduelle et une cristallinité de la couche de matériau de cible (410) variant sur la largeur de couche (w).

5. La cible de pulvérisation plane (400) selon l'une quelconque des revendications précédentes, dans laquelle la composition de couche sur la largeur de couche (w) reste constante.

6. La cible de pulvérisation plane (400) selon l'une quelconque des revendications précédentes, présentant une longueur de cible et une largeur de cible, la longueur étant plus grande que la largeur.

7. La cible de pulvérisation plane (400) selon l'une quelconque des revendications précédentes, dans laquelle les lattes comprennent un non-métal élémentaire, un métal élémentaire, un alliage, un composé métallique ou un matériau céramique.

8. La cible de pulvérisation plane (400) selon l'une quelconque des revendications précédentes, comprenant en outre un support (100) sous-jacent à la couche de matériau de cible (410).

9. La cible de pulvérisation plane (400) selon la revendication 8, dans laquelle une épaisseur (t) du support (100) est inférieure à une épaisseur de la couche de matériau de cible (410).

10. La cible de pulvérisation plane (400) selon la revendication 8 ou 9, dans laquelle le support (100) comporte une surface supérieure (110) apte à induire sur celle-ci la microstructure variant sur la largeur de couche (w).

11. La cible de pulvérisation plane (400) selon l'une quelconque des revendications précédentes, comprenant en outre une structure sacrificielle intercalée entre un support (100) sous-jacent à la couche de matériau de cible (410) et la couche de matériau de cible (410), si un support (100) est présent, ou sous-jacent à la couche de matériau de cible (410), si aucun support (100) n'est présent.

12. Un procédé de fabrication d'une cible de pulvérisation plane (400), comprenant :
a. la fourniture d'une structure d'appui (100) comportant une surface supérieure (110) ; et
b. la pulvérisation de lattes de matériau de cible sur la structure d'appui (100) depuis une source de pulvérisation (300) pour former une couche de matériau de cible (410) accumulée par une superposition de lattes sur la surface supérieure (110), la superposition de lattes présentant une largeur de couches (w), dans lequel la source de pulvérisation (300) constitue un angle (α) avec la surface supérieure (110), et dans lequel la source de pulvérisation (300) et la structure d'appui (100) se déplacent l'une par rapport à l'autre de telle manière que l'angle (a) varie sur la largeur de couche (w).

13. Le procédé selon la revendication 12, pour fabriquer simultanément une pluralité de cibles de pulvérisation planes (400), les étapes a et b comprenant :
a'. la fourniture d'une pluralité de surfaces supérieures (110), les surfaces supérieures (110) étant agencées autour d'un axe central (200) ; et
b'. la pulvérisation des lattes sur la structure d'appui (100) pour former une couche de matériau de cible (410) sur chacune des surfaces supérieures (110).

14. Le procédé selon la revendication 12 ou 13, dans lequel l'étape b comprend la rotation de la source de pulvérisation (300) et de la structure d'appui (100) l'une par rapport à l'autre.

15. Une cible de pulvérisation plane (400), pouvant être obtenue par le procédé selon l'une quelconque des revendications 12 à 14.
